# EUROPEAN PATENT SPECIFICATION

(11) **EP 4 080 504 B1**
(45) Date of publication and mention of the grant of the patent: **25.06.2025**
(21) Application number: 21741580.1
(22) Date of filing: 12.01.2021
(51) Int. Cl.: G10L 19/02, G10L 19/04, G10L 19/022, G10L 21/038, H03M 7/30

(54) **METHOD AND DEVICE FOR ENCODING AND DECODING AUDIO**
VERFAHREN UND VORRICHTUNG ZUR CODIERUNG UND DECODIERUNG VON AUDIO
PROCÉDÉ ET DISPOSITIF DE CODAGE ET DE DÉCODAGE AUDIO

(30) Priority: 13.01.2020 CN 202010033429
(43) Date of publication of application: 26.10.2022
(73) Proprietor: Huawei Technologies Co., Ltd., Shenzhen, Guangdong 518129 (CN)
(72) Inventor: XIA, Bingyin, Shenzhen, Guangdong 518129 (CN); LI, Jiawei, Shenzhen, Guangdong 518129 (CN); WANG, Zhe, Shenzhen, Guangdong 518129 (CN)
(74) Representative: Gill Jennings & Every LLP
(86) International application number: PCT/CN2021/071334
(87) International publication number: WO 2021/143694

(56) References cited:
- CN-A- 101 662 288
- CN-A- 104 021 796
- CN-A- 104 103 276
- CN-A- 109 448 741

## Description

This application claims priority to Chinese Patent Application No. 202010033429.6, filed with the China National Intellectual Property Administration on January 13, 2020 and entitled "AUDIO ENCODING AND DECODING METHOD AND AUDIO ENCODING AND DECODING DEVICE".

### TECHNICAL FIELD

This application relates to the field of audio signal encoding and decoding technologies, and in particular, to an audio encoding and decoding method and an audio encoding and decoding device.

### BACKGROUND

As quality of life is improved, a requirement for high-quality audio is constantly increased. To better transmit an audio signal on a limited bandwidth, the audio signal usually needs to be encoded first, and then an encoded bitstream is transmitted to a decoder side, see for example CN 104 103 276 A.

The decoder side decodes the received bitstream to obtain a decoded audio signal, and the decoded audio signal is used for play.

Therefore, how to improve encoding and decoding efficiency of performing frequency domain encoding and decoding on an audio signal becomes a technical problem that needs to be urgently resolved.

### SUMMARY

Embodiments of this application provide an audio encoding and decoding method and an audio encoding and decoding device, to improve encoding and decoding efficiency of audio signal.

To resolve the foregoing technical problem, the embodiments of this application provide the following technical solutions.

A first aspect of the present invention provides an audio encoding method. The method includes:
obtaining a current frame of an audio signal, where the current frame includes a high frequency band signal and a low frequency band signal;
obtaining a first encoding parameter of the current frame based on the high frequency band signal and the low frequency band signal;
obtaining a second encoding parameter of the current frame based on the high frequency band signal, where the second encoding parameter includes tone component information of the high frequency band signal;
obtaining a third encoding parameter of the current frame based on the high frequency band signal, where the third encoding parameter includes sub-band envelope information of a part of sub-band of the high frequency band signal that needs to be encoded; and
performing bitstream multiplexing on the first encoding parameter, the second encoding parameter, and the third encoding parameter, to obtain an encoded bitstream.

With reference to the first aspect, in an implementation, the obtaining a third encoding parameter of the current frame based on the high frequency band signal includes: determining, based on a sub-band that is in the high frequency band signal and that includes a tone component, a sub-band whose sub-band envelope information needs to be encoded, where the sub-band whose sub-band envelope information needs to be encoded has no intersection with the sub-band that includes a tone component.

With reference to the first aspect or the foregoing implementation of the first aspect, in an implementation, the obtaining a third encoding parameter of the current frame based on the high frequency band signal includes: obtaining the third encoding parameter of the current frame based on the second encoding parameter and the high frequency band signal.

With reference to the first aspect or the foregoing implementations of the first aspect, in an implementation, the tone component information of the high frequency band signal includes location information of a tone component of the high frequency band signal, and the location information of the tone component indicates the sub-band that is in the high frequency band signal and that includes a tone component.

A second aspect of the present invention provides an audio decoding method, including: obtaining an encoded bitstream; performing bitstream demultiplexing on the encoded bitstream, to obtain a first encoding parameter, a second encoding parameter, and a third encoding parameter of a current frame of an audio signal, where the second encoding parameter includes tone component information of a high frequency band signal of the current frame, and the third encoding parameter includes sub-band envelope information of a part of sub-band of the high frequency band signal; obtaining a first high frequency band signal and a first low frequency band signal of the current frame based on the first encoding parameter; obtaining a second high frequency band signal of the current frame based on the second encoding parameter, where the second high frequency band signal includes a reconstructed tone signal; performing frequency band extension based on the first low frequency band signal, the second encoding parameter, and the third encoding parameter, to obtain a third high frequency band signal of the current frame; obtaining a fused high frequency band signal of the current frame based on the first high frequency band signal, the second high frequency band signal, and the third high frequency band signal of the current frame; and obtaining an output audio signal of the current frame based on the first low frequency band signal and the fused high frequency band signal.

With reference to the second aspect, in an implementation, the tone component information includes quantity information and location information of a tone component included in the high frequency band signal of the current frame, and the location information of the tone component corresponds to a sub-band included in the high frequency band signal; and the performing frequency band extension based on the first low frequency band signal, the second encoding parameter, and the third encoding parameter, to obtain a third high frequency band signal of the current frame includes: determining, based on the quantity information and the location information of the tone component, a sub-band that is in the high frequency band signal of the current frame and that includes a tone component; and determining location information of the part of sub-band based on the sub-band that includes a tone component, where the sub-band that includes a tone component has no intersection with the part of sub-band; obtaining sub-band envelope information of the sub-band that is in the high frequency band signal of the current frame and that includes a tone component; and performing frequency band extension based on the sub-band envelope information of the sub-band that is in the high frequency band signal of the current frame and that includes a tone component, the sub-band envelope information of the part of sub-band, and the first low frequency band signal, to obtain the third high frequency band signal of the current frame.

With reference to the second aspect or the foregoing implementation of the second aspect, in an implementation, the sub-band envelope information of the sub-band that includes a tone component is a preset value.

A third aspect of the present invention provides an audio encoder, including: a signal obtaining unit, configured to obtain a current frame of an audio signal, where the current frame includes a high frequency band signal and a low frequency band signal; a parameter obtaining unit, configured to: obtain a first encoding parameter of the current frame based on the high frequency band signal and the low frequency band signal; obtain a second encoding parameter of the current frame based on the high frequency band signal, where the second encoding parameter includes tone component information of the high frequency band signal; and obtain a third encoding parameter of the current frame based on the high frequency band signal, where the third encoding parameter includes sub-band envelope information of a part of sub-band of the high frequency band signal that needs to be encoded; and an encoding unit, configured to perform bitstream multiplexing on the first encoding parameter, the second encoding parameter, and the third encoding parameter, to obtain an encoded bitstream.

With reference to the third aspect, in an implementation, the parameter obtaining unit is specifically configured to determine, based on a sub-band that is in the high frequency band signal and that includes a tone component, a sub-band whose sub-band envelope information needs to be encoded, where the sub-band whose sub-band envelope information needs to be encoded has no intersection with the sub-band that includes a tone component.

With reference to the third aspect or the foregoing implementation of the third aspect, in an implementation, the parameter obtaining unit is specifically configured to obtain the third encoding parameter of the current frame based on the second encoding parameter and the high frequency band signal.

With reference to the third aspect or the foregoing implementations of the third aspect, in an implementation, the tone component information of the high frequency band signal includes location information of a tone component of the high frequency band signal, and the location information of the tone component indicates the sub-band that is in the high frequency band signal and that includes a tone component.

A fourth aspect of the present invention provides an audio decoder, including: a receiving unit, configured to obtain an encoded bitstream; a demultiplexing unit, configured to perform bitstream demultiplexing on the encoded bitstream, to obtain a first encoding parameter, a second encoding parameter, and a third encoding parameter of a current frame of an audio signal, where the second encoding parameter includes tone component information of a high frequency band signal of the current frame, and the third encoding parameter includes sub-band envelope information of a part of sub-band of the high frequency band signal; a decoding unit, configured to: obtain a first high frequency band signal and a first low frequency band signal of the current frame based on the first encoding parameter; obtain a second high frequency band signal of the current frame based on the second encoding parameter, where the second high frequency band signal includes a reconstructed tone signal; perform frequency band extension based on the first low frequency band signal, the second encoding parameter, and the third encoding parameter, to obtain a third high frequency band signal of the current frame; a fusion unit, configured to obtain a fused high frequency band signal of the current frame based on the first high frequency band signal, the second high frequency band signal, and the third high frequency band signal of the current frame; and a reconstruction unit, configured to obtain an output audio signal of the current frame based on the first low frequency band signal and the fused high frequency band signal.

With reference to the fourth aspect, in an implementation, the tone component information includes quantity information and location information of a tone component included in the high frequency band signal of the current frame, and the location information of the tone component corresponds to a sub-band included in the high frequency band signal; and the decoding unit is specifically configured to: determine, based on the quantity information and the location information of the tone component, a sub-band that is in the high frequency band signal of the current frame and that includes a tone component; determine location information of the part of sub-band based on the sub-band that includes a tone component, where the sub-band that includes a tone component has no intersection with the part of sub-band; obtain sub-band envelope information of the sub-band that is in the high frequency band signal of the current frame and that includes a tone component; and perform frequency band extension based on the sub-band envelope information of the sub-band that is in the high frequency band signal of the current frame and that includes a tone component, the sub-band envelope information of the part of sub-band, and the first low frequency band signal, to obtain the third high frequency band signal of the current frame.

With reference to the fourth aspect, in an implementation, the sub-band envelope information of the sub-band that includes a tone component is a preset value.

According to a fifth aspect, an embodiment of this application provides a computer-readable storage medium. The computer-readable storage medium stores instructions, and when the instructions are run on a computer, the computer is enabled to perform the method in the first aspect or the second aspect.

It can be learned from the foregoing descriptions that, in the embodiments of the present invention, the third encoding parameter is obtained based on the second encoding parameter, so that the to-be-encoded third encoding parameter includes only a parameter that is not included in the second encoding parameter, thereby avoiding encoding of redundant information and reducing bit consumption. Specifically, a sub-band envelope that needs to be encoded in the third encoding parameter may be determined based on a tone component included in the second encoding parameter, so that the tone component and the sub-band envelope are not encoded for a same sub-band, thereby reducing information redundancy, and improving encoding efficiency.

### BRIEF DESCRIPTION OF DRAWINGS

FIG. 1 is a schematic diagram of a structure of an audio encoding and decoding system according to an embodiment of this application;
FIG. 2 is a schematic flowchart of an audio encoding method according to an embodiment of this application;
FIG. 3 is a schematic flowchart of an audio decoding method according to an embodiment of this application;
FIG. 4 is a schematic diagram of a mobile terminal according to an embodiment of this application;
FIG. 5 is a schematic diagram of a network element according to an embodiment of this application;
FIG. 6 is a schematic diagram of a composition structure of an audio encoding device according to an embodiment of this application;
FIG. 7 is a schematic diagram of a composition structure of an audio decoding device according to an embodiment of this application;
FIG. 8 is a schematic diagram of a composition structure of another audio encoding device according to an embodiment of this application; and
FIG. 9 is a schematic diagram of a composition structure of another audio decoding device according to an embodiment of this application.

### DESCRIPTION OF EMBODIMENTS

The following describes embodiments of this application with reference to accompanying drawings.

In the specification, claims, and accompanying drawings of this application, the terms "first", "second", and the like are intended to distinguish between similar objects but do not necessarily indicate a specific order or sequence. It should be understood that the terms used in such a way are interchangeable in proper circumstances, and this is merely a discrimination manner for describing objects having a same attribute in embodiments of this application. In addition, the terms "include", "have", and any other variants mean to cover the non-exclusive inclusion, so that a process, method, system, product, or device that includes a series of units is not necessarily limited to those units, but may include other units not expressly listed or inherent to such a process, method, system, product, or device.

An audio signal in the embodiments of this application is an input signal in an audio encoding device, and the audio signal may include a plurality of frames. For example, a current frame may be specifically a frame in the audio signal. In the embodiments of this application, an example of encoding and decoding the audio signal of the current frame is used for description. A frame before or after the current frame in the audio signal may be correspondingly encoded and decoded according to an encoding and decoding mode of the audio signal of the current frame. An encoding and decoding process of the frame before or after the current frame in the audio signal is not described. In addition, the audio signal in the embodiments of this application may be a mono audio signal, or may be a stereo signal. The stereo signal may be an original stereo signal, or may be a stereo signal formed by two channels of signals (a left-channel signal and a right-channel signal) included in a multi-channel signal, or may be a stereo signal formed by two channels of signals generated by at least three channels of signals included in a multi-channel signal. This is not limited in the embodiments of this application.

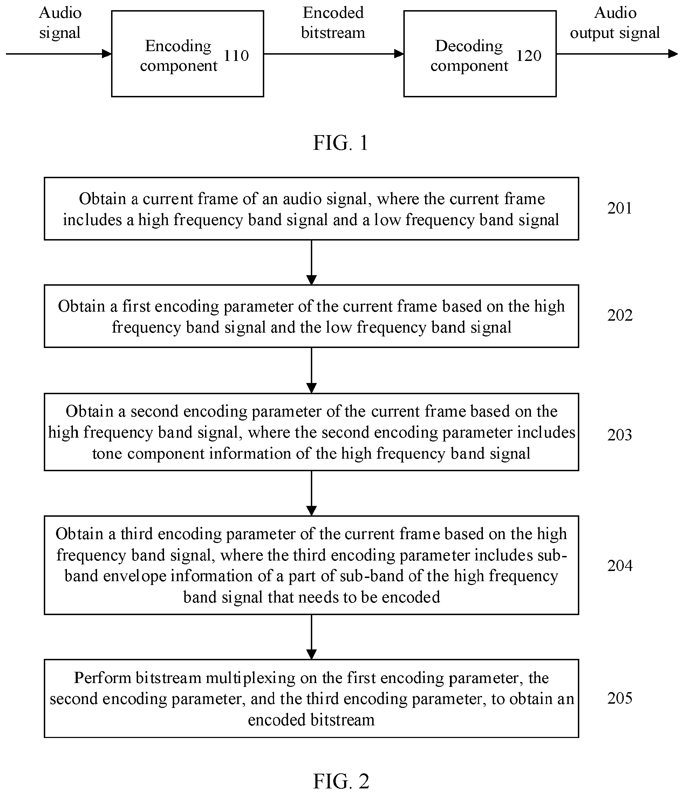

FIG. 1 is a schematic diagram of a structure of an audio encoding and decoding system according to an example embodiment of this application. The audio encoding and decoding system includes an encoding component 110 and a decoding component 120.

The encoding component 110 is configured to encode a current frame (an audio signal) in frequency domain or time domain. Optionally, the encoding component 110 may be implemented by software, or may be implemented by hardware, or may be implemented in a form of a combination of software and hardware. This is not limited in this embodiment of this application.

When the encoding component 110 encodes the current frame in frequency domain or time domain, in a possible implementation, steps shown in FIG. 2 may be included.

In this embodiment of this application, after completing encoding, the encoding component 110 may generate an encoded bitstream, and the encoding component 110 may send the encoded bitstream to the decoding component 120, so that the decoding component 120 can receive the encoded bitstream. Then, the decoding component 120 obtains an audio output signal from the encoded bitstream.

It should be noted that an encoding method shown in FIG. 2 is merely an example rather than a limitation. An execution sequence of steps in FIG. 2 is not limited in this embodiment of this application. The encoding method shown in FIG. 2 may alternatively include more or fewer steps. This is not limited in this embodiment of this application.

Optionally, the encoding component 110 may be connected to the decoding component 120 wiredly or wirelessly. The decoding component 120 may obtain, by using the connection between the decoding component 120 and the encoding component 110, an encoded bitstream generated by the encoding component 110. Alternatively, the encoding component 110 may store the generated encoded bitstream in a memory, and the decoding component 120 reads the encoded bitstream in the memory.

Optionally, the decoding component 120 may be implemented by software, or may be implemented by hardware, or may be implemented in a form of a combination of software and hardware. This is not limited in this embodiment of this application.

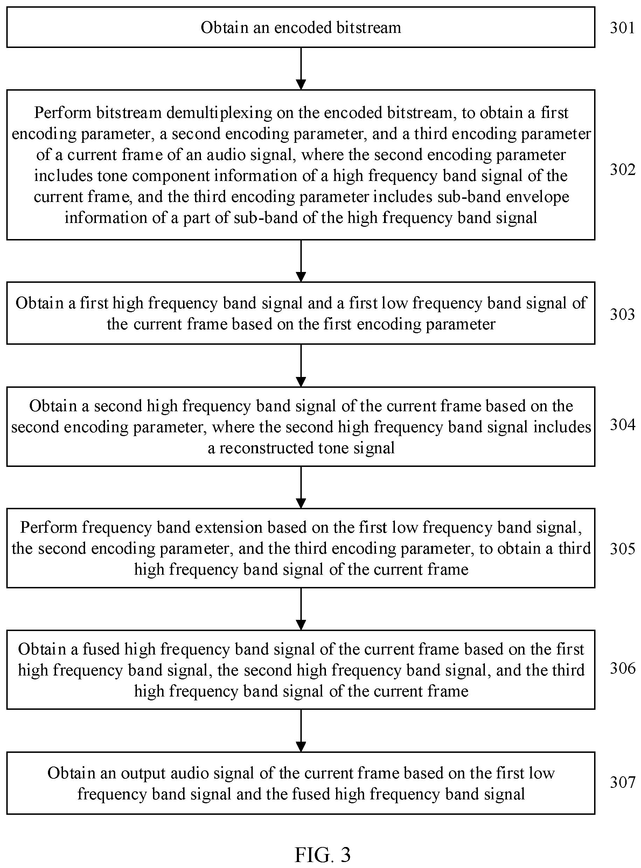

When the decoding component 120 decodes a current frame (an audio signal) in frequency domain or time domain, in a possible implementation, steps shown in FIG. 3 may be included.

Optionally, the encoding component 110 and the decoding component 120 may be disposed in a same device, or may be disposed in different devices. The device may be a terminal having an audio signal processing function, such as a mobile phone, a tablet computer, a laptop computer, a desktop computer, a Bluetooth speaker, a pen recorder, or a wearable device. Alternatively, the device may be a network element having an audio signal processing capability in a core network or a wireless network. This is not limited in this embodiment.

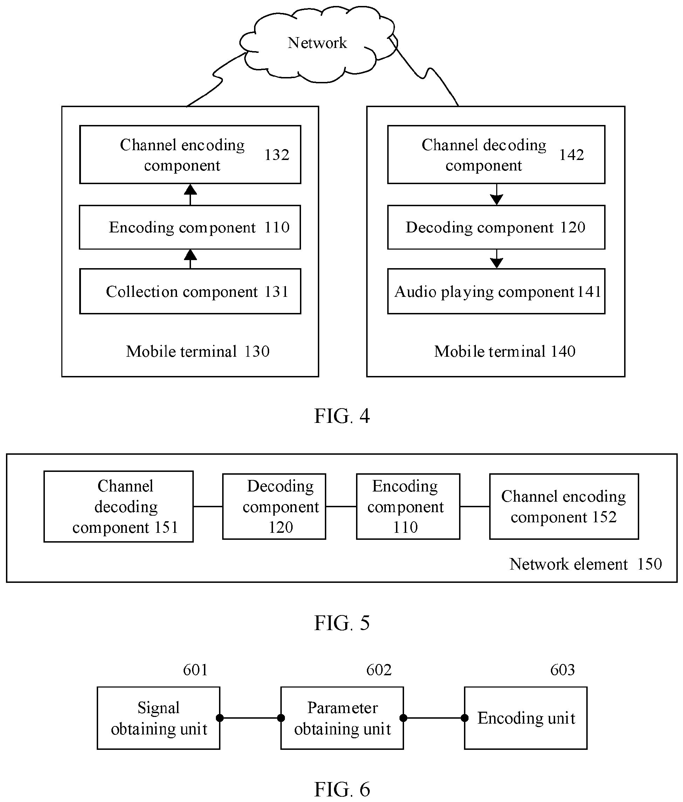

For example, as shown in FIG. 4, the following example is used for description in this embodiment. The encoding component 110 is disposed in a mobile terminal 130, and the decoding component 120 is disposed in a mobile terminal 140. The mobile terminal 130 and the mobile terminal 140 are mutually independent electronic devices having an audio signal processing capability. For example, the mobile terminal 130 and the mobile terminal 140 may be mobile phones, wearable devices, virtual reality (virtual reality, VR) devices, or augmented reality (augmented reality, AR) devices. In addition, the mobile terminal 130 and the mobile terminal 140 are connected by using a wireless or wired network.

Optionally, the mobile terminal 130 may include a collection component 131, the encoding component 110, and a channel encoding component 132. The collection component 131 is connected to the encoding component 110, and the encoding component 110 is connected to the encoding component 132.

Optionally, the mobile terminal 140 may include an audio playing component 141, the decoding component 120, and a channel decoding component 142. The audio playing component 141 is connected to the decoding component 120, and the decoding component 120 is connected to the channel decoding component 142.

After collecting an audio signal through the collection component 131, the mobile terminal 130 encodes the audio signal by using the encoding component 110, to obtain an encoded bitstream; and then encodes the encoded bitstream by using the channel encoding component 132, to obtain a transmission signal.

The mobile terminal 130 sends the transmission signal to the mobile terminal 140 by using the wireless or wired network.

After receiving the transmission signal, the mobile terminal 140 decodes the transmission signal by using the channel decoding component 142, to obtain the encoded bitstream; decodes the encoded bitstream by using the decoding component 110, to obtain the audio signal; and plays the audio signal by using the audio playing component. It may be understood that the mobile terminal 130 may alternatively include the components included in the mobile terminal 140, and the mobile terminal 140 may alternatively include the components included in the mobile terminal 130.

For example, as shown in FIG. 5, the following example is used for description. The encoding component 110 and the decoding component 120 are disposed in one network element 150 having an audio signal processing capability in a core network or wireless network.

Optionally, the network element 150 includes a channel decoding component 151, the decoding component 120, the encoding component 110, and a channel encoding component 152. The channel decoding component 151 is connected to the decoding component 120, the decoding component 120 is connected to the encoding component 110, and the encoding component 110 is connected to the channel encoding component 152.

After receiving a transmission signal sent by another device, the channel decoding component 151 decodes the transmission signal to obtain a first encoded bitstream. The decoding component 120 decodes the encoded bitstream to obtain an audio signal. The encoding component 110 encodes the audio signal to obtain a second encoded bitstream. The channel encoding component 152 encodes the second encoded bitstream to obtain the transmission signal.

The another device may be a mobile terminal having an audio signal processing capability, or may be another network element having an audio signal processing capability. This is not limited in this embodiment.

Optionally, the encoding component 110 and the decoding component 120 in the network element may transcode an encoded bitstream sent by a mobile terminal.

Optionally, in this embodiment of this application, a device on which the encoding component 110 is installed may be referred to as an audio encoding device. In actual implementation, the audio encoding device may also have an audio decoding function. This is not limited in this embodiment of this application.

Optionally, in this embodiment of this application, a device on which the decoding component 120 is installed may be referred to as an audio decoding device. In actual implementation, the audio decoding device may also have an audio encoding function. This is not limited in this embodiment of this application.

FIG. 2 describes a procedure of an audio encoding method according to an embodiment of the present invention.

201: Obtain a current frame of an audio signal, where the current frame includes a high frequency band signal and a low frequency band signal.

The current frame may be any frame in the audio signal, and the current frame may include a high frequency band signal and a low frequency band signal. Division of a high frequency band signal and a low frequency band signal may be determined by using a frequency band threshold, a signal higher than the frequency band threshold is a high frequency band signal, and a signal lower than the frequency band threshold is a low frequency band signal. The frequency band threshold may be determined based on a transmission bandwidth and data processing capabilities of the encoding component 110 and the decoding component 120. This is not limited herein.

The high frequency band signal and the low frequency band signal are relative. For example, a signal lower than a frequency is a low frequency band signal, but a signal higher than the frequency is a high frequency band signal (a signal corresponding to the frequency may be a low frequency band signal or a high frequency band signal). The frequency varies with a bandwidth of the current frame. For example, when the current frame is a wideband signal of 0 to 8 kHz, the frequency may be 4 kHz. When the current frame is an ultra-wideband signal of 0 to 16 kHz, the frequency may be 8 kHz.

202: Obtain a first encoding parameter of the current frame based on the high frequency band signal and the low frequency band signal.

203: Obtain a second encoding parameter of the current frame based on the high frequency band signal, where the second encoding parameter includes tone component information of the high frequency band signal.

In an implementation, the tone component information includes at least one of tone component quantity information, tone component location information, tone component amplitude information, or tone component energy information. There is only one piece of amplitude information and only one piece of energy information.

204: Obtain a third encoding parameter of the current frame based on the high frequency band signal, where the third encoding parameter includes sub-band envelope information of a part of sub-band of the high frequency band signal that needs to be encoded.

In this embodiment of the present invention, the third encoding parameter may be a parameter used to perform frequency band extension, for example, may include sub-band envelope information.

In an implementation, the obtaining a third encoding parameter of the current frame based on the high frequency band signal includes: determining, based on a sub-band that is in the high frequency band signal and that includes a tone component, a sub-band whose sub-band envelope information needs to be encoded, where the sub-band whose sub-band envelope information needs to be encoded has no intersection with the sub-band that includes a tone component.

In an embodiment, the tone component information of the high frequency band signal includes location information of a tone component in the high frequency band signal, and the location information of the tone component indicates a sub-band that is in the high frequency band signal and that includes a tone component. In this case, the obtaining a third encoding parameter of the current frame based on the high frequency band signal includes: obtaining the third encoding parameter of the current frame based on the second encoding parameter and the high frequency band signal.

In some implementations, there may be some redundant parts between the second encoding parameter and the third encoding parameter. Therefore, based on the second encoding parameter, screening may be performed on the third encoding parameter that needs to be encoded, to obtain a part that is in the third encoding parameter and that is not included in the second encoding parameter. For example, in some implementations, it may be considered that a tone component and a sub-band envelope are redundant. Therefore, if a sub-band includes a tone component, that is, the second encoding parameter includes tone component information of the sub-band, an envelope of the sub-band does not need to be transmitted to a decoder.

In an implementation, a screening process may include: obtaining, based on quantity information and location information of a tone component, quantity information of a tone component included in each high frequency sub-band; performing screening on envelope information of the high frequency sub-band based on the quantity information of the tone component included in each high frequency sub-band; and if the quantity information of the tone component in the current high-frequency sub-band is not 0, that is, the current high-frequency sub-band includes a tone component, skipping encoding the envelope of the current high-frequency sub-band; or otherwise encoding the envelope information of the current sub-band for transmission.

Specifically, in an implementation, the obtaining the third encoding parameter of the current frame based on the second encoding parameter may include: determining, based on the location information of the tone component in the high frequency band signal, a sub-band that is in the high frequency band signal and that includes a tone component; and determining, based on a sub-band that is in the high frequency band signal and that includes a tone component, a sub-band whose sub-band envelope information needs to be encoded, where the sub-band whose sub-band envelope information needs to be encoded has no intersection with the sub-band that includes a tone component.

205: Perform bitstream multiplexing on the first encoding parameter, the second encoding parameter, and the third encoding parameter, to obtain an encoded bitstream.

It can be learned from the foregoing descriptions that, in this embodiment of the present invention, the third encoding parameter is obtained based on the second encoding parameter, so that the to-be-encoded third encoding parameter includes only a parameter that is not included in the second encoding parameter, thereby avoiding encoding of redundant information and reducing bit consumption. Specifically, a sub-band envelope that needs to be encoded in the third encoding parameter may be determined based on a tone component included in the second encoding parameter, so that the tone component and the sub-band envelope are not encoded for a same sub-band, thereby reducing information redundancy, and improving encoding efficiency.

It may be understood that, if each sub-band in the high frequency band signal includes a tone component, there is no sub-band in the high frequency band signal whose sub-band envelope information needs to be encoded. In this case, if the third encoding parameter includes only the sub-band envelope information that needs to be encoded, an audio encoder does not obtain the third encoding parameter. That is, the audio encoder only needs to obtain the first encoding parameter and the second encoding parameter and perform bitstream multiplexing. Correspondingly, an audio decoder may directly perform decoding based on the first encoding parameter and the second encoding parameter.

Similarly, no sub-band in the high frequency band signal may include a tone component. In this case, if the second encoding parameter includes only the tone component information, the audio encoder does not obtain the second encoding parameter. That is, the audio encoder only needs to obtain the first encoding parameter and the third encoding parameter and perform bitstream multiplexing. Correspondingly, the audio decoder may directly perform decoding based on the first encoding parameter and the third encoding parameter.

FIG. 3 describes a procedure of an audio decoding method according to an embodiment of the present invention.

301: Obtain an encoded bitstream.

302: Perform bitstream demultiplexing on the encoded bitstream, to obtain a first encoding parameter, a second encoding parameter, and a third encoding parameter of a current frame of an audio signal, where the second encoding parameter includes tone component information of a high frequency band signal of the current frame, and the third encoding parameter includes sub-band envelope information of a part of sub-band of the high frequency band signal.

The tone component information includes quantity information and location information of a tone component included in the high frequency band signal of the current frame, and the location information of the tone component corresponds to a sub-band included in the high frequency band signal.

303: Obtain a first high frequency band signal and a first low frequency band signal of the current frame based on the first encoding parameter.

304: Obtain a second high frequency band signal of the current frame based on the second encoding parameter, where the second high frequency band signal includes a reconstructed tone signal.

305: Perform frequency band extension based on the first low frequency band signal, the second encoding parameter, and the third encoding parameter, to obtain a third high frequency band signal of the current frame.

In an implementation, the third high frequency band signal may be obtained in the following manner: obtaining quantity information of a tone component in each high frequency sub-band based on the quantity information and the location information of the tone component in the tone component information, and obtaining envelope information of all high frequency sub-bands based on the quantity information of the tone component in each sub-band with reference to envelope information of some high frequency sub-bands in the third encoding parameter; and obtaining an extended high frequency band signal (that is, the third high frequency band signal) based on the envelope information of all the high frequency sub-bands and the first low frequency band signal.

In a specific implementation, the performing frequency band extension based on the first low frequency band signal, the second encoding parameter, and the third encoding parameter, to obtain a third high frequency band signal of the current frame may specifically include: determining, based on the quantity information and the location information of the tone component, a sub-band that is in the high frequency band signal of the current frame and that includes a tone component; and determining location information of the part of sub-band based on the sub-band that includes a tone component, where the sub-band that includes a tone component has no intersection with the part of sub-band; obtaining sub-band envelope information of the sub-band that is in the high frequency band signal of the current frame and that includes a tone component; and performing frequency band extension based on the sub-band envelope information of the sub-band that is in the high frequency band signal of the current frame and that includes a tone component, the sub-band envelope information of the part of sub-band, and the first low frequency band signal, to obtain the third high frequency band signal of the current frame.

In an implementation, the sub-band envelope information of the sub-band that includes a tone component is a preset value.

306: Obtain a fused high frequency band signal of the current frame based on the first high frequency band signal, the second high frequency band signal, and the third high frequency band signal of the current frame.

307: Obtain an output audio signal of the current frame based on the first low frequency band signal and the fused high frequency band signal.

In an implementation, when tone component detection is performed on the high frequency band signal, a quantity tone_cnt[tile] of tone components in the high frequency band signal may be obtained, and the quantity of tone components may be converted into a quantity of tone components in each sub-band of the high frequency band signal with reference to location information of the tone component in the high frequency band signal, and is denoted as tone_cnt_sfb[sfb]. Herein, sfb is a sub-band sequence number, a value range of sfb is [0, N_{sfb}-1], and N_{sfb} is a quantity of sub-bands in the high frequency band signal of the current frame.

A sub-band envelope of each sub-band of the high frequency band signal may be obtained by using a frequency band extension algorithm, and is denoted as env_sfb[sfb].

It is determined whether tone_cnt_sfb [sfb] of each sub-band is 0 for N_{sfb} sub-bands of the high frequency band signal. If tone_cnt_sfb[sfb] is not 0, env_sfb[sfb] is removed. In this case, env_sfb[sfb] does not need to be encoded.

After the foregoing processing process, a length of a remaining high frequency sub-band envelope parameter env_sfb_mod is the quantity of sub-bands in the high frequency band signal minus a quantity of sub-bands including a tone component, that is, N_{sfb}-N_{sfb_has_tone}. Herein, N_{sfb_has_tone} is the quantity of sub-bands including a tone component in all the sub-bands of the high frequency band signal.

It is assumed that the quantity of sub-bands included in the high frequency band signal is 5, that is, sub-band sequence numbers are 0 to 4, and tone_cnt_sfb[1] and tone_cnt_sfb[3] are not 0. Therefore, env_sfb[1] and env_sfb[3] can be removed. A length of a corresponding sub-band envelope sequence of the high frequency band signal is also changed from 5 to 5-2, that is, 3.

Correspondingly, a decoding process may be expressed as follows:
A decoder obtains signal class information of the current frame from the encoded bitstream (bitstream), and the signal class information may indicate whether the current frame includes a tone component. If the signal class indicates that a tone component is included, a quantity parameter and a location parameter of a tone component in the high frequency band signal of the current frame are further obtained from the bitstream, and converted into a quantity parameter tone_cnt_sfb of a tone component of each sub-band. A length of the parameter is N_{sfb}.

Based on the quantity parameter tone_cnt_sfb of the tone component of the sub-band and the quantity parameter N_{sfb} of the high frequency sub-band, a quantity of to-be-decoded sub-band envelopes that need to be used in a bandwidth extension algorithm may be determined. A determining process is as follows:
It is determined whether tone_cnt_sfb[sfb] is 0 for a sub-band sequence number sfb (in a value range of 0 to N_{sfb}-1), and statistics collection is performed on a quantity of sub-bands whose tone_cnt_sfb[sfb] is not 0, that is, a quantity of high frequency sub-bands including a tone component, which is denoted as N_{sfb_has_tone}.

In the bandwidth extension algorithm, the quantity of to-be-decoded sub-band envelopes is the quantity of sub-bands in the high frequency band signal minus the quantity of sub-bands including a tone component in the high frequency band signal, that is, N_{sfb}-N_{sfb_has_tone}.

A sub-band envelope of a high frequency sub-band that does not include a tone component is obtained from the bitstream through decoding, and a length of the sub-band envelope is N_{sfb}-N_{sfb_has_tone}.

A sub-band envelope sequence env_sfb_mod of the high frequency sub-band that does not include a tone component is mapped to each high frequency sub-band, that is, env_sfb_mod whose length is N_{sfb}-N_{sfb_has_tone} is restored to env_sfb whose length is N_{sfb}.

A restoration process is described as follows:
For all sub-bands sfb (in a value range of 0 to N_{sfb}-1), if the sub-band does not include a tone component, that is, tone_cnt_sfb[sfb] is 0, a sub-band envelope env_sfb_mod[idx] (an initial value of idx is 0) is selected from the sub-band envelope sequence env_sfb_mod obtained through decoding, to serve as a sub-band envelope env_sfb[sfb] of an sfb^{th} sub-band, and idx is incremented by 1. If the sub-band includes a tone component, env_sfb[sfb] is set to 1.

Pseudocode is described as follows:

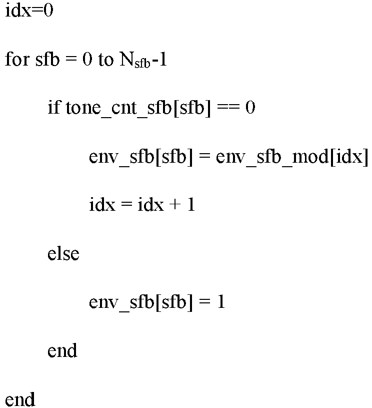

If the current sub-band sfb does not include a tone component, frequency band extension is performed by using the sub-band envelope env_sfb[sfb] obtained through decoding.

If the current sub-band sfb includes a tone component, the tone component may be reconstructed, and fused with the extended high frequency band signal and the decoded high frequency band signal based on noise floor information. Alternatively, in an implementation, the sub-band envelope of the sub-band that includes a tone component may be set to a preset value.

FIG. 6 describes a structure of an audio encoder according to an embodiment of the present invention, including a signal obtaining unit 601, a parameter obtaining unit 602, and an encoding unit 603.

The signal obtaining unit 601 is configured to obtain a current frame of an audio signal, where the current frame includes a high frequency band signal and a low frequency band signal.

The parameter obtaining unit 602 is configured to: obtain a first encoding parameter of the current frame based on the high frequency band signal and the low frequency band signal; obtain a second encoding parameter of the current frame based on the high frequency band signal, where the second encoding parameter includes tone component information of the high frequency band signal; and obtain a third encoding parameter of the current frame based on the high frequency band signal, where the third encoding parameter includes sub-band envelope information of a part of sub-band of the high frequency band signal that needs to be encoded.

In an embodiment, when obtaining the third encoding parameter of the current frame based on the high frequency band signal, the parameter obtaining unit 602 may be specifically configured to determine, based on a sub-band that is in the high frequency band signal and that includes a tone component, a sub-band whose sub-band envelope information needs to be encoded, where the sub-band whose sub-band envelope information needs to be encoded has no intersection with the sub-band that includes a tone component.

In an embodiment, the tone component information of the high frequency band signal includes location information of a tone component in the high frequency band signal, and the location information of the tone component indicates the sub-band that is in the high frequency band signal and that includes a tone component. When obtaining the third encoding parameter of the current frame based on the high frequency band signal, the parameter obtaining unit 602 may be specifically configured to obtain the third encoding parameter of the current frame based on the second encoding parameter and the high frequency band signal.

The encoding unit 603 is configured to perform bitstream multiplexing on the first encoding parameter, the second encoding parameter, and the third encoding parameter, to obtain an encoded bitstream.

For specific implementation of the encoder, refer to the foregoing audio encoding method. Details are not described herein again.

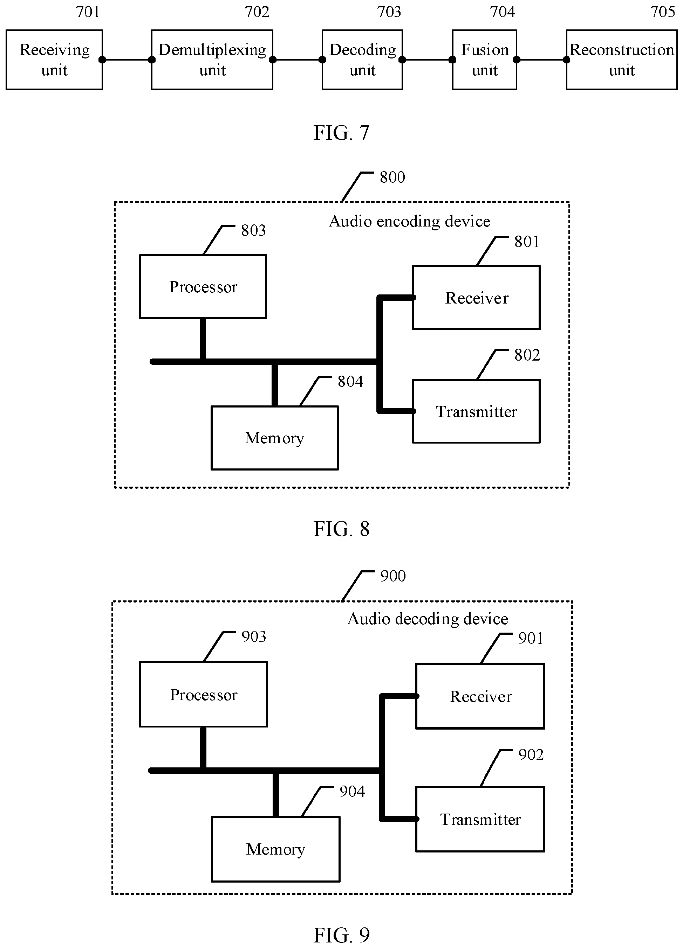

FIG. 7 describes a structure of an audio decoder according to an embodiment of the present invention, including a receiving unit 701, a demultiplexing unit 702, a decoding unit 703, a fusion unit 704, and a reconstruction unit 705.

The receiving unit 701 is configured to obtain an encoded bitstream.

The demultiplexing unit 702 is configured to perform bitstream demultiplexing on the encoded bitstream, to obtain a first encoding parameter, a second encoding parameter, and a third encoding parameter of a current frame of an audio signal, where the second encoding parameter includes tone component information of a high frequency band signal of the current frame, and the third encoding parameter includes sub-band envelope information of a part of sub-band of the high frequency band signal.

The tone component information includes quantity information and location information of a tone component included in the high frequency band signal of the current frame, and the location information of the tone component corresponds to a sub-band included in the high frequency band signal.

The decoding unit 703 is configured to: obtain a first high frequency band signal and a first low frequency band signal of the current frame based on the first encoding parameter; obtain a second high frequency band signal of the current frame based on the second encoding parameter, where the second high frequency band signal includes a reconstructed tone signal; perform frequency band extension based on the first low frequency band signal, the second encoding parameter, and the third encoding parameter, to obtain a third high frequency band signal of the current frame.

In an implementation, when performing frequency band extension based on the first low frequency band signal, the second encoding parameter, and the third encoding parameter, to obtain the third high frequency band signal of the current frame, the decoding unit 703 may be specifically configured to: determine, based on the quantity information and the location information of the tone component, a sub-band that is in the high frequency band signal of the current frame and that includes a tone component; and determine location information of the part of sub -band based on the sub-band that includes a tone component, where the sub-band that includes a tone component has no intersection with the part of sub-band; obtain sub-band envelope information of the sub-band that is in the high frequency band signal of the current frame and that includes a tone component; and perform frequency band extension based on the sub-band envelope information of the sub-band that is in the high frequency band signal of the current frame and that includes a tone component, the sub-band envelope information of the part of sub-band, and the first low frequency band signal, to obtain the third high frequency band signal of the current frame.

In an implementation, the sub-band envelope information of the sub-band that includes a tone component is a preset value.

The fusion unit 704 is configured to obtain a fused high frequency band signal of the current frame based on the first high frequency band signal, the second high frequency band signal, and the third high frequency band signal of the current frame.

The reconstruction unit 705 is configured to obtain an output audio signal of the current frame based on the first low frequency band signal and the fused high frequency band signal.

For specific implementation of the decoder, refer to the foregoing audio decoding method. Details are not described herein again.

An embodiment of this application further provides a computer storage medium. The computer storage medium stores a program. The program is executed to perform some or all of the steps described in the method embodiments.

The following describes another audio encoding device according to an embodiment of this application. Referring to FIG. 8, the audio encoding device 800 includes:
a receiver 801, a transmitter 802, a processor 803, and a memory 804 (there may be one or more processors 803 in the audio encoding device 800, and an example in which there is one processor is used in FIG. 8). In some embodiments of this application, the receiver 801, the transmitter 802, the processor 803, and the memory 804 may be connected through a bus or in another manner. In FIG. 8, an example in which the receiver 801, the transmitter 802, the processor 803, and the memory 804 are connected through the bus is used.

The memory 804 may include a read-only memory and a random access memory, and provide an instruction and data to the processor 803. A part of the memory 804 may further include a non-volatile random access memory (non-volatile random access memory, NVRAM). The memory 804 stores an operating system and an operation instruction, an executable module or a data structure, or a subnet thereof, or an extended set thereof. The operation instruction may include various operation instructions, to implement various operations. The operating system may include various system programs for implementing various basic services and processing hardware-based tasks.

The processor 803 controls an operation of the audio encoding device, and the processor 803 may also be referred to as a central processing unit (central processing unit, CPU). In specific application, the components of the audio encoding device are coupled together by using a bus system. In addition to a data bus, the bus system may further include a power bus, a control bus, and a status signal bus. However, for clear description, various types of buses in the figure are marked as the bus system.

The method disclosed in the foregoing embodiments of this application may be applied to the processor 803, or may be implemented by the processor 803. The processor 803 may be an integrated circuit chip and has a signal processing capability. In an implementation process, the steps in the foregoing methods can be implemented by using a hardware integrated logical circuit in the processor 803, or by using instructions in a form of software. The processor 803 may be a general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or transistor logic device, or a discrete hardware component. The processor may implement or perform the methods, steps, and logical block diagrams that are disclosed in the embodiments of this application. The general-purpose processor may be a microprocessor, any conventional processor, or the like. Steps of the methods disclosed with reference to the embodiments of this application may be directly performed and completed by a hardware decoding processor, or may be performed and completed by using a combination of hardware and software modules in the decoding processor. The software module may be located in a mature storage medium in the art, for example, a random access memory, a flash memory, a read-only memory, a programmable read-only memory, an electrically erasable programmable memory, or a register. The storage medium is located in the memory 804, and a processor 803 reads information in the memory 804 and completes the steps in the foregoing methods in combination with hardware of the processor.

The receiver 801 may be configured to: receive input number or character information, and generate signal input related to related settings and function control of the audio encoding device. The transmitter 802 may include a display device such as a display, and the transmitter 802 may be configured to output number or character information through an external interface.

In this embodiment of this application, the processor 803 is configured to perform the foregoing audio encoding method shown in FIG. 2.

The following describes another audio decoding device according to an embodiment of this application. Referring to FIG. 9, the audio decoding device 900 includes:
a receiver 901, a transmitter 902, a processor 903, and a memory 904 (there may be one or more processors 903 in the audio decoding device 900, and an example in which there is one processor is used in FIG. 9). In some embodiments of this application, the receiver 901, the transmitter 902, the processor 903, and the memory 904 may be connected through a bus or in another manner. In FIG. 9, an example in which the receiver 901, the transmitter 902, the processor 903, and the memory 904 are connected through the bus is used.

The memory 904 may include a read-only memory and a random access memory, and provide instructions and data to the processor 903. A part of the memory 904 may further include an NVRAM. The memory 904 stores an operating system and an operation instruction, an executable module or a data structure, or a subset thereof, or an extended set thereof. The operation instruction may include various operation instructions to implement various operations. The operating system may include various system programs for implementing various basic services and processing hardware-based tasks.

The processor 903 controls an operation of the audio decoding device, and the processor 903 may also be referred to as a CPU. In specific application, the components of the audio decoding device are coupled together by using a bus system. In addition to a data bus, the bus system may further include a power bus, a control bus, and a status signal bus. However, for clear description, various types of buses in the figure are marked as the bus system.

The methods disclosed in the embodiments of this application may be applied to the processor 903, or implemented by the processor 903. The processor 903 may be an integrated circuit chip and has a signal processing capability. In an implementation process, the steps in the foregoing methods can be implemented by using a hardware integrated logical circuit in the processor 903, or by using instructions in a form of software. The foregoing processor 903 may be a general purpose processor, a DSP, an ASIC, an FPGA or another programmable logic device, a discrete gate or transistor logic device, or a discrete hardware component. The processor may implement or perform the methods, steps, and logical block diagrams that are disclosed in the embodiments of this application. The general-purpose processor may be a microprocessor, any conventional processor, or the like. Steps of the methods disclosed with reference to the embodiments of this application may be directly performed and completed by a hardware decoding processor, or may be performed and completed by using a combination of hardware and software modules in the decoding processor. The software module may be located in a mature storage medium in the art, for example, a random access memory, a flash memory, a read-only memory, a programmable read-only memory, an electrically erasable programmable memory, or a register. The storage medium is located in the memory 904, and the processor 903 reads information in the memory 904 and completes the steps in the foregoing methods in combination with hardware of the processor.

In this embodiment of this application, the processor 903 is configured to perform the foregoing audio decoding method shown in FIG. 3.

In another possible design, when the audio encoding device or the audio decoding device is a chip in a terminal, the chip includes a processing unit and a communications unit. The processing unit may be, for example, a processor. The communications unit may be, for example, an input/output interface, a pin, or a circuit. The processing unit may execute computer-executable instructions stored in a storage unit, so that the chip in the terminal performs the method in the first aspect. Optionally, the storage unit is a storage unit in the chip, for example, a register or a cache. Alternatively, the storage unit may be a storage unit that is in the terminal and that is located outside the chip, for example, a read-only memory (read-only memory, ROM) or another type of static storage device that may store static information and instructions, for example, a random access memory (random access memory, RAM).

The processor mentioned anywhere above may be a general-purpose central processing unit, a microprocessor, an ASIC, or one or more integrated circuits configured to control program execution of the method according to the first aspect.

In addition, it should be noted that the described apparatus embodiments are merely examples. The units described as separate parts may or may not be physically separate, and parts displayed as units may or may not be physical units, and may be located in one position, or may be distributed on a plurality of network units. Some or all the modules may be selected according to an actual need to achieve the objectives of the solutions of the embodiments. In addition, in the accompanying drawings of the apparatus embodiments provided in this application, connection relationships between modules indicate that the modules have communication connections with each other, which may be specifically implemented as one or more communications buses or signal cables.

Based on the description of the foregoing implementations, a person skilled in the art may clearly understand that this application may be implemented by software in addition to necessary universal hardware, or certainly may be implemented by dedicated hardware, including an application-specific integrated circuit, a dedicated CPU, a dedicated memory, a dedicated component, and the like. Generally, any functions that can be performed by a computer program can be easily implemented by using corresponding hardware, and a specific hardware structure used to achieve a same function may be of various forms, for example, in a form of an analog circuit, a digital circuit, a dedicated circuit, or the like. However, in this application, a software program implementation is a better implementation in most cases. Based on such an understanding, the technical solutions of this application essentially or the part contributing to the conventional technology may be implemented in a form of a software product. The software product is stored in a readable storage medium, such as a floppy disk, a USB flash drive, a removable hard disk, a ROM, a RAM, a magnetic disk, or a compact disc of a computer, and includes several instructions for instructing a computer device (which may be a personal computer, a server, a network device, or the like) to perform the methods described in the embodiments of this application.

All or some of the foregoing embodiments may be implemented by using software, hardware, firmware, or any combination thereof. When software is used to implement the embodiments, all or some of the embodiments may be implemented in a form of a computer program product.

The computer program product includes one or more computer instructions. When the computer program instructions are loaded and executed on a computer, the procedures or functions according to the embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, such as a server or a data center, integrating one or more usable media. The usable medium may be a magnetic medium (for example, a floppy disk, a hard disk or a magnetic tape), an optical medium (for example, a DVD), a semiconductor medium (for example, a solid-state drive (Solid-State Drive, SSD)), or the like.

## Claims

1. An audio encoding method, wherein the method comprises:
obtaining a current frame of an audio signal, wherein the current frame comprises a high frequency band signal and a low frequency band signal;
obtaining a first encoding parameter of the current frame based on the high frequency band signal and the low frequency band signal;
obtaining a second encoding parameter of the current frame based on the high frequency band signal, wherein the second encoding parameter comprises tone component information of the high frequency band signal;
obtaining a third encoding parameter of the current frame based on the high frequency band signal, wherein the third encoding parameter comprises sub-band envelope information of a part of sub-band of the high frequency band signal that needs to be encoded; and
performing bitstream multiplexing on the first encoding parameter, the second encoding parameter, and the third encoding parameter, to obtain an encoded bitstream.

2. The method according to claim 1, wherein the obtaining a third encoding parameter of the current frame based on the high frequency band signal comprises:
determining, based on a sub-band that is in the high frequency band signal and that comprises a tone component, a sub-band whose sub-band envelope information needs to be encoded, wherein the sub-band whose sub-band envelope information needs to be encoded has no intersection with the sub-band that comprises a tone component.

3. The method according to claim 1 or 2, wherein the obtaining a third encoding parameter of the current frame based on the high frequency band signal comprises:
obtaining the third encoding parameter of the current frame based on the second encoding parameter and the high frequency band signal.

4. The method according to any one of claims 1 to 3, wherein the tone component information of the high frequency band signal comprises location information of a tone component of the high frequency band signal, and the location information of the tone component indicates the sub-band that is in the high frequency band signal and that comprises a tone component.

5. An audio decoding method, comprising:
obtaining an encoded bitstream;
performing bitstream demultiplexing on the encoded bitstream, to obtain a first encoding parameter, a second encoding parameter, and a third encoding parameter of a current frame of an audio signal, wherein the second encoding parameter comprises tone component information of a high frequency band signal of the current frame, and the third encoding parameter comprises sub-band envelope information of a part of sub-band of the high frequency band signal;
obtaining a first high frequency band signal and a first low frequency band signal of the current frame based on the first encoding parameter;
obtaining a second high frequency band signal of the current frame based on the second encoding parameter, wherein the second high frequency band signal comprises a reconstructed tone signal;
performing frequency band extension based on the first low frequency band signal, the second encoding parameter, and the third encoding parameter, to obtain a third high frequency band signal of the current frame;
obtaining a fused high frequency band signal of the current frame based on the first high frequency band signal, the second high frequency band signal, and the third high frequency band signal of the current frame; and
obtaining an output audio signal of the current frame based on the first low frequency band signal and the fused high frequency band signal.

6. The method according to claim 5, wherein the tone component information comprises quantity information and location information of a tone component comprised in the high frequency band signal of the current frame, and the location information of the tone component corresponds to a sub-band comprised in the high frequency band signal; and
the performing frequency band extension based on the first low frequency band signal, the second encoding parameter, and the third encoding parameter, to obtain a third high frequency band signal of the current frame comprises:
determining, based on the quantity information and the location information of the tone component, a sub-band that is in the high frequency band signal of the current frame and that comprises a tone component; and determining location information of the part of sub-band based on the sub-band that comprises a tone component, wherein the sub-band that comprises a tone component has no intersection with the part of sub-band;
obtaining sub-band envelope information of the sub-band that is in the high frequency band signal of the current frame and that comprises a tone component; and
performing frequency band extension based on the sub-band envelope information of the sub-band that is in the high frequency band signal of the current frame and that comprises a tone component, the sub-band envelope information of the part of sub-band, and the first low frequency band signal, to obtain the third high frequency band signal of the current frame.

7. The method according to claim 6, wherein the sub-band envelope information of the sub-band that comprises a tone component is a preset value.

8. An audio encoder, comprising:
a signal obtaining unit, configured to obtain a current frame of an audio signal, wherein the current frame comprises a high frequency band signal and a low frequency band signal;
a parameter obtaining unit, configured to: obtain a first encoding parameter of the current frame based on the high frequency band signal and the low frequency band signal; obtain a second encoding parameter of the current frame based on the high frequency band signal, wherein the second encoding parameter comprises tone component information of the high frequency band signal; and obtain a third encoding parameter of the current frame based on the high frequency band signal, wherein the third encoding parameter comprises sub-band envelope information of a part of sub-band of the high frequency band signal that needs to be encoded; and
an encoding unit, configured to perform bitstream multiplexing on the first encoding parameter, the second encoding parameter, and the third encoding parameter, to obtain an encoded bitstream.

9. The audio encoder according to claim 8, wherein the parameter obtaining unit is specifically configured to determine, based on a sub-band that is in the high frequency band signal and that comprises a tone component, a sub-band whose sub-band envelope information needs to be encoded, wherein the sub-band whose sub-band envelope information needs to be encoded has no intersection with the sub-band that comprises a tone component.

10. The audio encoder according to claim 8 or 9, wherein the parameter obtaining unit is specifically configured to obtain the third encoding parameter of the current frame based on the second encoding parameter and the high frequency band signal.

11. The audio encoder according to any one of claims 8 to 10, wherein the tone component information of the high frequency band signal comprises location information of a tone component of the high frequency band signal, and the location information of the tone component indicates the sub-band that is in the high frequency band signal and that comprises a tone component.

12. An audio decoder, comprising:
a receiving unit, configured to obtain an encoded bitstream;
a demultiplexing unit, configured to perform bitstream demultiplexing on the encoded bitstream, to obtain a first encoding parameter, a second encoding parameter, and a third encoding parameter of a current frame of an audio signal, wherein the second encoding parameter comprises tone component information of a high frequency band signal of the current frame, and the third encoding parameter comprises sub-band envelope information of a part of sub-band of the high frequency band signal;
a decoding unit, configured to: obtain a first high frequency band signal and a first low frequency band signal of the current frame based on the first encoding parameter; obtain a second high frequency band signal of the current frame based on the second encoding parameter, wherein the second high frequency band signal comprises a reconstructed tone signal; perform frequency band extension based on the first low frequency band signal, the second encoding parameter, and the third encoding parameter, to obtain a third high frequency band signal of the current frame;
a fusion unit, configured to obtain a fused high frequency band signal of the current frame based on the first high frequency band signal, the second high frequency band signal, and the third high frequency band signal of the current frame; and
a reconstruction unit, configured to obtain an output audio signal of the current frame based on the first low frequency band signal and the fused high frequency band signal.

13. The audio decoder according to claim 12, wherein the tone component information comprises quantity information and location information of a tone component comprised in the high frequency band signal of the current frame, and the location information of the tone component corresponds to a sub-band comprised in the high frequency band signal; and
the decoding unit is specifically configured to: determine, based on the quantity information and the location information of the tone component, a sub-band that is in the high frequency band signal of the current frame and that comprises a tone component; determine location information of the part of sub-band based on the sub-band that comprises a tone component, wherein the sub-band that comprises a tone component has no intersection with the part of sub-band; obtain sub-band envelope information of the sub-band that is in the high frequency band signal of the current frame and that comprises a tone component; and perform frequency band extension based on the sub-band envelope information of the sub-band that is in the high frequency band signal of the current frame and that comprises a tone component, the sub-band envelope information of the part of sub-band, and the first low frequency band signal, to obtain the third high frequency band signal of the current frame.

14. The audio decoder according to claim 13, wherein the sub-band envelope information of the sub-band that comprises a tone component is a preset value.

15. A computer-readable storage medium, comprising instructions, wherein when the instructions are run on a computer, the computer is enabled to perform the method according to any one of claims 1 to 7.

## Patentansprüche

1. Audiocodierungsverfahren, wobei das Verfahren Folgendes umfasst:
Erlangen eines aktuellen Frames eines Audiosignals, wobei der aktuelle Frame ein Hochfrequenzbandsignal und ein Niederfrequenzbandsignal umfasst;
Erlangen eines ersten Codierungsparameters des aktuellen Frames basierend auf dem Hochfrequenzbandsignal und dem Niederfrequenzbandsignal;
Erlangen eines zweiten Codierungsparameters des aktuellen Frames basierend auf dem Hochfrequenzbandsignal, wobei der zweite Codierungsparameter Tonkomponenteninformationen des Hochfrequenzbandsignals umfasst;
Erlangen eines dritten Codierungsparameters des aktuellen Frames basierend auf dem Hochfrequenzbandsignal, wobei der dritte Codierungsparameter Teilbandhüllkurveninformationen eines Teils des Teilbands des Hochfrequenzbandsignals umfasst, das codiert werden muss; und
Durchführen einer Bitstrom-Multiplexierung an dem ersten Codierungsparameter, dem zweiten Codierungsparameter und dem dritten Codierungsparameter, um einen codierten Bitstrom zu erlangen.

2. Verfahren nach Anspruch 1, wobei das Erlangen eines dritten Codierungsparameters des aktuellen Frames basierend auf dem Hochfrequenzbandsignal Folgendes umfasst:
Bestimmen, basierend auf einem Teilband, das sich in dem Hochfrequenzbandsignal befindet und das eine Tonkomponente umfasst, eines Teilbands, dessen Teilbandhüllkurveninformationen codiert werden müssen, wobei das Teilband, dessen Teilbandhüllkurveninformationen codiert werden müssen, keine Schnittmenge mit dem Teilband aufweist, das eine Tonkomponente umfasst.

3. Verfahren nach Anspruch 1 oder 2, wobei das Erlangen eines dritten Codierungsparameters des aktuellen Frames basierend auf dem Hochfrequenzbandsignal Folgendes umfasst:
Erlangen des dritten Codierungsparameters des aktuellen Frames basierend auf dem zweiten Codierungsparameter und dem Hochfrequenzbandsignal.

4. Verfahren nach einem der Ansprüche 1 bis 3, wobei die Tonkomponenteninformationen des Hochfrequenzbandsignals Positionsinformationen einer Tonkomponente des Hochfrequenzbandsignals umfassen und die Positionsinformationen der Tonkomponente das Teilband angeben, das sich in dem Hochfrequenzbandsignal befindet und das eine Tonkomponente umfasst.

5. Audiodecodierungsverfahren, Folgendes umfassend:
Erlangen eines codierten Bitstroms;
Durchführen einer Bitstrom-Demultiplexierung an dem codierten Bitstrom, um einen ersten Codierungsparameter, einen zweiten Codierungsparameter und einen dritten Codierungsparameter eines aktuellen Frames eines Audiosignals zu erlangen, wobei der zweite Codierungsparameter Tonkomponenteninformationen eines Hochfrequenzbandsignals des aktuellen Frames umfasst und der dritte Codierungsparameter Teilbandhüllkurveninformationen eines Teils des Teilbands des Hochfrequenzbandsignals umfasst;
Erlangen eines ersten Hochfrequenzbandsignals und eines ersten Niederfrequenzbandsignals des aktuellen Frames basierend auf dem ersten Codierungsparameter;
Erlangen eines zweiten Hochfrequenzbandsignals des aktuellen Frames basierend auf dem zweiten Codierungsparameter, wobei das zweite Hochfrequenzbandsignal ein rekonstruiertes Tonsignal umfasst;
Durchführen einer Frequenzbanderweiterung basierend auf dem ersten Niederfrequenzbandsignal, dem zweiten Codierungsparameter und dem dritten Codierungsparameter, um ein drittes Hochfrequenzbandsignal des aktuellen Frames zu erlangen;
Erlangen eines fusionierten Hochfrequenzbandsignals des aktuellen Frames basierend auf dem ersten Hochfrequenzbandsignal, dem zweiten Hochfrequenzbandsignal und dem dritten Hochfrequenzbandsignal des aktuellen Frames; und
Erlangen eines Ausgangsaudiosignals des aktuellen Frames basierend auf dem ersten Niederfrequenzbandsignal und dem fusionierten Hochfrequenzbandsignal.

6. Verfahren nach Anspruch 5, wobei die Tonkomponenteninformationen Mengeninformationen und Positionsinformationen einer Tonkomponente umfassen, die in dem Hochfrequenzbandsignal des aktuellen Frames umfasst ist, und die Positionsinformationen der Tonkomponente einem Teilband entsprechen, das in dem Hochfrequenzbandsignal umfasst ist; und das Durchführen einer Frequenzbanderweiterung basierend auf dem ersten Niederfrequenzbandsignal, dem zweiten Codierungsparameter und dem dritten Codierungsparameter, um ein drittes Hochfrequenzbandsignal des aktuellen Frames zu erlangen, Folgendes umfasst:
Bestimmen, basierend auf den Mengeninformationen und den Positionsinformationen der Tonkomponente, eines Teilbands, das sich in dem Hochfrequenzbandsignal des aktuellen Frames befindet und das eine Tonkomponente umfasst; und Bestimmen von Positionsinformationen des Teils des Teilbands basierend auf dem Teilband, das eine Tonkomponente umfasst, wobei das Teilband, das eine Tonkomponente umfasst, keine Schnittmenge mit dem Teil des Teilbands aufweist;
Erlangen von Teilbandhüllkurveninformationen des Teilbands, das sich in dem Hochfrequenzbandsignal des aktuellen Frames befindet und das eine Tonkomponente umfasst; und
Durchführen einer Frequenzbanderweiterung basierend auf den Teilbandhüllkurveninformationen des Teilbands, das sich in dem Hochfrequenzbandsignal des aktuellen Frames befindet und das eine Tonkomponente, die Teilbandhüllkurveninformationen des Teils des Teilbands und das erste Niederfrequenzbandsignal umfasst, um das dritte Hochfrequenzbandsignal des aktuellen Frames zu erlangen.

7. Verfahren nach Anspruch 6, wobei die Teilbandhüllkurveninformationen des Teilbands, das eine Tonkomponente umfasst, ein voreingestellter Wert sind.

8. Audiocodierer, umfassend:
eine Signalerlangungseinheit, die dazu konfiguriert ist, einen aktuellen Frame eines Audiosignals zu erlangen, wobei der aktuelle Frame ein Hochfrequenzbandsignal und ein Niederfrequenzbandsignal umfasst;
eine Parametererlangungseinheit, die zu Folgendem konfiguriert ist: Erlangen eines ersten Codierungsparameters des aktuellen Frames basierend auf dem Hochfrequenzbandsignal und dem Niederfrequenzbandsignal; Erlangen eines zweiten Codierungsparameters des aktuellen Frames basierend auf dem Hochfrequenzbandsignal, wobei der zweite Codierungsparameter Tonkomponenteninformationen des Hochfrequenzbandsignals umfasst; und Erlangen eines dritten Codierungsparameters des aktuellen Frames basierend auf dem Hochfrequenzbandsignal, wobei der dritte Codierungsparameter Teilbandhüllkurveninformationen eines Teils des Teilbands des Hochfrequenzbandsignals umfasst, das codiert werden muss; und
eine Codiereinheit, die dazu konfiguriert ist, eine Bitstrom-Multiplexierung an dem ersten Codierungsparameter, dem zweiten Codierungsparameter und dem dritten Codierungsparameter durchzuführen, um einen codierten Bitstrom zu erlangen.

9. Audiocodierer nach Anspruch 8, wobei die Parametererlangungseinheit speziell dazu konfiguriert ist, basierend auf einem Teilband, das sich in dem Hochfrequenzbandsignal befindet und das eine Tonkomponente umfasst, ein Teilband zu bestimmen, dessen Teilbandhüllkurveninformationen codiert werden müssen, wobei das Teilband, dessen Teilbandhüllkurveninformationen codiert werden müssen, keine Schnittmenge mit dem Teilband aufweist, das eine Tonkomponente umfasst.

10. Audiocodierer nach Anspruch 8 oder 9, wobei die Parametererlangungseinheit speziell dazu konfiguriert ist, den dritten Codierungsparameter des aktuellen Frames basierend auf dem zweiten Codierungsparameter und dem Hochfrequenzbandsignal zu erlangen.

11. Audiocodierer nach einem der Ansprüche 8 bis 10, wobei die Tonkomponenteninformationen des Hochfrequenzbandsignals Positionsinformationen einer Tonkomponente des Hochfrequenzbandsignals umfassen und die Positionsinformationen der Tonkomponente das Teilband angeben, das sich in dem Hochfrequenzbandsignal befindet und das eine Tonkomponente umfasst.

12. Audiodecodierer, umfassend:
eine Empfangseinheit, die dazu konfiguriert ist, einen codierten Bitstrom zu erlangen;
eine Demultiplexierungseinheit, die dazu konfiguriert ist, eine Bitstrom-Demultiplexierung an dem codierten Bitstrom durchzuführen, um einen ersten Codierungsparameter, einen zweiten Codierungsparameter und einen dritten Codierungsparameter eines aktuellen Frames eines Audiosignals zu erlangen, wobei der zweite Codierungsparameter Tonkomponenteninformationen eines Hochfrequenzbandsignals des aktuellen Frames umfasst und der dritte Codierungsparameter Teilbandhüllkurveninformationen eines Teils des Teilbands des Hochfrequenzbandsignals umfasst;
eine Decodierungseinheit, die zu Folgendem konfiguriert ist:
Erlangen eines ersten Hochfrequenzbandsignals und eines ersten Niederfrequenzbandsignals des aktuellen Frames basierend auf dem ersten Codierungsparameter; Erlangen eines zweiten Hochfrequenzbandsignals des aktuellen Frames basierend auf dem zweiten Codierungsparameter, wobei das zweite Hochfrequenzbandsignal ein rekonstruiertes Tonsignal umfasst;
Durchführen einer Frequenzbanderweiterung basierend auf dem ersten Niederfrequenzbandsignal, dem zweiten Codierungsparameter und dem dritten Codierungsparameter, um ein drittes Hochfrequenzbandsignal des aktuellen Frames zu erlangen;
eine Fusionseinheit, die dazu konfiguriert ist, ein fusioniertes Hochfrequenzbandsignal des aktuellen Frames basierend auf dem ersten Hochfrequenzbandsignal, dem zweiten Hochfrequenzbandsignal und dem dritten Hochfrequenzbandsignal des aktuellen Frames zu erlangen; und
eine Rekonstruktionseinheit, die dazu konfiguriert ist, ein Ausgangsaudiosignal des aktuellen Frames basierend auf dem ersten Niederfrequenzbandsignal und dem fusionierten Hochfrequenzbandsignal zu erlangen.

13. Audiodecodierer nach Anspruch 12, wobei die Tonkomponenteninformationen Mengeninformationen und Positionsinformationen einer Tonkomponente umfassen, die in dem Hochfrequenzbandsignal des aktuellen Frames umfasst ist, und die Positionsinformationen der Tonkomponente einem in dem Hochfrequenzbandsignal umfassten Teilband entsprechen; und
die Decodierungseinheit speziell zu Folgendem konfiguriert ist: Bestimmen, basierend auf den Mengeninformationen und den Positionsinformationen der Tonkomponente, eines Teilbands, das sich in dem Hochfrequenzbandsignal des aktuellen Frames befindet und das eine Tonkomponente umfasst; Bestimmen, basierend auf dem Teilband, das eine Tonkomponente umfasst, von Positionsinformationen des Teils des Teilbands, wobei das Teilband, das eine Tonkomponente umfasst, keine Schnittmenge mit dem Teil des Teilbands aufweist; Erlangen von Teilbandhüllkurveninformationen des Teilbands, das sich in dem Hochfrequenzbandsignal des aktuellen Frames befindet und das eine Tonkomponente umfasst; und Durchführen einer Frequenzbanderweiterung basierend auf den Teilbandhüllkurveninformationen des Teilbands, das sich in dem Hochfrequenzbandsignal des aktuellen Frames befindet und das eine Tonkomponente, die Teilbandhüllkurveninformationen des Teils des Teilbands und das erste Niederfrequenzbandsignal umfasst, um das dritte Hochfrequenzbandsignal des aktuellen Frames zu erlangen.

14. Audiodecodierer nach Anspruch 13, wobei die Teilbandhüllkurveninformationen des Teilbands, das eine Tonkomponente umfasst, ein voreingestellter Wert sind.

15. Computerlesbares Speichermedium, umfassend Anweisungen, wobei, wenn die Anweisungen auf einem Computer ausgeführt werden, der Computer in die Lage versetzt wird, das Verfahren nach einem der Ansprüche 1 bis 7 durchzuführen.

## Revendications

1. Procédé de codage audio, dans lequel le procédé comprend :
l'obtention d'une trame actuelle d'un signal audio, dans lequel la trame actuelle comprend un signal de bande haute fréquence et un signal de bande basse fréquence ;
l'obtention d'un premier paramètre de codage de la trame actuelle sur la base du signal de bande haute fréquence et du signal de bande basse fréquence ;
l'obtention d'un deuxième paramètre de codage de la trame actuelle sur la base du signal de bande haute fréquence, dans lequel le deuxième paramètre de codage comprend des informations de composante de tonalité du signal de bande haute fréquence ;
l'obtention d'un troisième paramètre de codage de la trame actuelle sur la base du signal de bande haute fréquence, dans lequel le troisième paramètre de codage comprend des informations d'enveloppe de sous-bande d'une partie de sous-bande du signal de bande haute fréquence qui doit être codée ; et
la réalisation d'un multiplexage de flux binaire sur le premier paramètre de codage, le deuxième paramètre de codage et le troisième paramètre de codage, pour obtenir un flux binaire codé.

2. Procédé selon la revendication 1, dans lequel l'obtention d'un troisième paramètre de codage de la trame actuelle sur la base du signal de bande haute fréquence comprend :
la détermination, sur la base d'une sous-bande qui se trouve dans le signal de bande haute fréquence et qui comprend une composante de tonalité, d'une sous-bande dont les informations d'enveloppe de sous-bande doivent être codées, dans lequel la sous-bande dont les informations d'enveloppe de sous-bande doivent être codées n'a pas d'intersection avec la sous-bande qui comprend une composante de tonalité.

3. Procédé selon la revendication 1 ou 2, dans lequel l'obtention d'un troisième paramètre de codage de la trame actuelle sur la base du signal de bande haute fréquence comprend :
l'obtention du troisième paramètre de codage de la trame actuelle sur la base du deuxième paramètre de codage et du signal de bande haute fréquence.

4. Procédé selon l'une quelconque des revendications 1 à 3, dans lequel les informations de composante de tonalité du signal de bande haute fréquence comprennent des informations de localisation d'une composante de tonalité du signal de bande haute fréquence, et les informations de localisation de la composante de tonalité indiquent la sous-bande qui se trouve dans le signal de bande haute fréquence et qui comprend une composante de tonalité.

5. Procédé de décodage audio, comprenant :
l'obtention d'un flux binaire codé ;
la réalisation d'un démultiplexage de flux binaire sur le flux binaire codé, pour obtenir un premier paramètre de codage, un deuxième paramètre de codage et un troisième paramètre de codage d'une trame actuelle d'un signal audio, dans lequel le deuxième paramètre de codage comprend des informations de composante de tonalité d'un signal de bande haute fréquence de la trame actuelle, et le troisième paramètre de codage comprend des informations d'enveloppe de sous-bande d'une partie de sous-bande du signal de bande haute fréquence ;
l'obtention d'un premier signal de bande haute fréquence et d'un premier signal de bande basse fréquence de la trame actuelle sur la base du premier paramètre de codage ;
l'obtention d'un deuxième signal de bande haute fréquence de la trame actuelle sur la base du deuxième paramètre de codage, dans lequel le deuxième signal de bande haute fréquence comprend un signal de tonalité reconstruit ;
la réalisation d'une extension de bande de fréquence sur la base du premier signal de bande basse fréquence, du deuxième paramètre de codage et du troisième paramètre de codage, pour obtenir un troisième signal de bande haute fréquence de la trame actuelle ;
l'obtention d'un signal de bande haute fréquence fusionné de la trame actuelle sur la base du premier signal de bande haute fréquence, du deuxième signal de bande haute fréquence et du troisième signal de bande haute fréquence de la trame actuelle ; et
l'obtention d'un signal audio de sortie de la trame actuelle sur la base du premier signal de bande basse fréquence et du signal de bande haute fréquence fusionné.

6. Procédé selon la revendication 5, dans lequel les informations de composante de tonalité comprennent des informations de quantité et des informations de localisation d'une composante de tonalité comprise dans le signal de bande haute fréquence de la trame actuelle, et les informations de localisation de la composante de tonalité correspondent à une sous-bande comprise dans le signal de bande haute fréquence ; et
la réalisation d'une extension de bande de fréquence sur la base du premier signal de bande basse fréquence, du deuxième paramètre de codage et du troisième paramètre de codage, pour obtenir un troisième signal de bande haute fréquence de la trame actuelle comprend :
la détermination, sur la base des informations de quantité et des informations de localisation de la composante de tonalité, d'une sous-bande qui se trouve dans le signal de bande haute fréquence de la trame actuelle et qui comprend une composante de tonalité ; et la détermination d'informations de localisation de la partie de sous-bande sur la base de la sous-bande qui comprend une composante de tonalité, dans lequel la sous-bande qui comprend une composante de tonalité n'a pas d'intersection avec la partie de sous-bande ;
l'obtention d'informations d'enveloppe de sous-bande de la sous-bande qui se trouve dans le signal de bande haute fréquence de la trame actuelle et qui comprend une composante de tonalité ; et
la réalisation d'une extension de bande de fréquence sur la base des informations d'enveloppe de sous-bande de la sous-bande qui se trouve dans le signal de bande haute fréquence de la trame actuelle et qui comprend une composante de tonalité, des informations d'enveloppe de sous-bande de la partie de sous-bande et du premier signal de bande basse fréquence, pour obtenir le troisième signal de bande haute fréquence de la trame actuelle.

7. Procédé selon la revendication 6, dans lequel les informations d'enveloppe de sous-bande de la sous-bande qui comprend une composante de tonalité sont une valeur prédéfinie.

8. Codeur audio, comprenant :
une unité d'obtention de signal, configurée pour obtenir une trame actuelle d'un signal audio, dans lequel la trame actuelle comprend un signal de bande haute fréquence et un signal de bande basse fréquence ;
une unité d'obtention de paramètres, configurée pour : obtenir un premier paramètre de codage de la trame actuelle sur la base du signal de bande haute fréquence et du signal de bande basse fréquence ; obtenir un deuxième paramètre de codage de la trame actuelle sur la base du signal de bande haute fréquence, dans lequel le deuxième paramètre de codage comprend des informations de composante de tonalité du signal de bande haute fréquence ;
et obtenir un troisième paramètre de codage de la trame actuelle sur la base du signal de bande haute fréquence, dans lequel le troisième paramètre de codage comprend des informations d'enveloppe de sous-bande d'une partie de sous-bande du signal de bande haute fréquence qui doit être codée ; et
une unité de codage, configurée pour réaliser un multiplexage de flux binaire sur le premier paramètre de codage, le deuxième paramètre de codage et le troisième paramètre de codage, pour obtenir un flux binaire codé.

9. Codeur audio selon la revendication 8, dans lequel l'unité d'obtention de paramètres est spécifiquement configurée pour déterminer, sur la base d'une sous-bande qui se trouve dans le signal de bande haute fréquence et qui comprend une composante de tonalité, une sous-bande dont les informations d'enveloppe de sous-bande doivent être codées, dans lequel la sous-bande dont les informations d'enveloppe de sous-bande doivent être codées n'a pas d'intersection avec la sous-bande qui comprend une composante de tonalité.

10. Codeur audio selon la revendication 8 ou 9, dans lequel l'unité d'obtention de paramètres est spécifiquement configurée pour obtenir le troisième paramètre de codage de la trame actuelle sur la base du deuxième paramètre de codage et du signal de bande haute fréquence.

11. Codeur audio selon l'une quelconque des revendications 8 à 10, dans lequel les informations de composante de tonalité du signal de bande haute fréquence comprennent des informations de localisation d'une composante de tonalité du signal de bande haute fréquence, et les informations de localisation de la composante de tonalité indiquent la sous-bande qui se trouve dans le signal de bande haute fréquence et qui comprend une composante de tonalité.

12. Décodeur audio, comprenant :
une unité de réception, configurée pour obtenir un flux binaire codé ;
une unité de démultiplexage, configurée pour réaliser un démultiplexage de flux binaire sur le flux binaire codé, pour obtenir un premier paramètre de codage, un deuxième paramètre de codage et un troisième paramètre de codage d'une trame actuelle d'un signal audio, dans lequel le deuxième paramètre de codage comprend des informations de composante de tonalité d'un signal de bande haute fréquence de la trame actuelle, et le troisième paramètre de codage comprend des informations d'enveloppe de sous-bande d'une partie de sous-bande du signal de bande haute fréquence ;
une unité de décodage, configurée pour : obtenir un premier signal de bande haute fréquence et un premier signal de bande basse fréquence de la trame actuelle sur la base du premier paramètre de codage ; obtenir un deuxième signal de bande haute fréquence de la trame actuelle sur la base du deuxième paramètre de codage, dans lequel le deuxième signal de bande haute fréquence comprend un signal de tonalité reconstruit ; réaliser une extension de bande de fréquence sur la base du premier signal de bande basse fréquence, du deuxième paramètre de codage et du troisième paramètre de codage, pour obtenir un troisième signal de bande haute fréquence de la trame actuelle ;
une unité de fusion, configurée pour obtenir un signal de bande haute fréquence fusionné de la trame actuelle sur la base du premier signal de bande haute fréquence, du deuxième signal de bande haute fréquence et du troisième signal de bande haute fréquence de la trame actuelle ; et
une unité de reconstruction, configurée pour obtenir un signal audio de sortie de la trame actuelle sur la base du premier signal de bande basse fréquence et du signal de bande haute fréquence fusionné.

13. Décodeur audio selon la revendication 12, dans lequel les informations de composante de tonalité comprennent des informations de quantité et des informations de localisation d'une composante de tonalité comprise dans le signal de bande haute fréquence de la trame actuelle, et les informations de localisation de la composante de tonalité correspondent à une sous-bande comprise dans le signal de bande haute fréquence ; et
l'unité de décodage est spécifiquement configurée pour :
déterminer, sur la base des informations de quantité et des informations de localisation de la composante de tonalité, une sous-bande qui se trouve dans le signal de bande haute fréquence de la trame actuelle et qui comprend une composante de tonalité ;
déterminer des informations de localisation de la partie de sous-bande sur la base de la sous-bande qui comprend une composante de tonalité, dans lequel la sous-bande qui comprend une composante de tonalité n'a pas d'intersection avec la partie de sous-bande ; obtenir des informations d'enveloppe de sous-bande de la sous-bande qui se trouve dans le signal de bande haute fréquence de la trame actuelle et qui comprend une composante de tonalité ; et réaliser une extension de bande de fréquence sur la base des informations d'enveloppe de sous-bande de la sous-bande qui se trouve dans le signal de bande haute fréquence de la trame actuelle et qui comprend une composante de tonalité, des informations d'enveloppe de sous-bande de la partie de sous-bande et du premier signal de bande basse fréquence, pour obtenir le troisième signal de bande haute fréquence de la trame actuelle.

14. Décodeur audio selon la revendication 13, dans lequel les informations d'enveloppe de sous-bande de la sous-bande qui comprend une composante de tonalité sont une valeur prédéfinie.

15. Support de stockage lisible par ordinateur, comprenant des instructions, dans lequel, lorsque les instructions sont exécutées sur un ordinateur, l'ordinateur est activé pour réaliser le procédé selon l'une quelconque des revendications 1 à 7.
